# EUROPEAN PATENT APPLICATION

(11) **EP 4 425 566 A1**
(43) Date of publication of application: **04.09.2024**
(21) Application number: 24158577.7
(22) Date of filing: 20.02.2024
(51) Int. Cl.: H01L 29/16, H01L 21/28, H01L 29/417, H01L 21/329, H01L 29/872, H01L 29/47, H01L 21/66, H01L 29/06

(54) **SEMICONDUCTOR DEVICE AND METHOD FOR MANUFACTURING SEMICONDUCTOR DEVICE**

(30) Priority: 01.03.2023 JP 2023030621; 31.05.2023 JP 2023089876; 13.11.2023 JP 2023192957
(71) Applicant: Kabushiki Kaisha Toshiba, Tokyo 105-0023 (JP); Toshiba Electronic Devices & Storage Corporation, Tokyo 105-0023 (JP)
(72) Inventor: TAKAGI, Shigeaki, Tokyo (JP); YOSHIHASHI, Hideo, Tokyo (JP); KURAGUCHI, Tomomi, Tokyo (JP); HIRATA, Naofumi, Tokyo (JP); ARAKAKI, Yohei, Tokyo (JP)
(74) Representative: Kramer Barske Schmidtchen Patentanwälte PartG mbB

(57) **Abstract**

A semiconductor device according to an embodiment includes a first electrode, a second electrode, a silicon carbide layer provided between the first electrode and the second electrode and including a first silicon carbide region of n type, a titanium nitride layer provided between the first electrode and the first silicon carbide region, and an intermediate layer provided between the titanium nitride layer and the first silicon carbide region and containing silicon nitride.

## Description

### CROSS-REFERENCE TO RELATED APPLICATION

This application is based upon and claims the benefit of priority from Japanese Patent Application No. 2023-030621, filed on March 1, 2023, Japanese Patent Application No. 2023-089876, filed on May 31, 2023, and Japanese Patent Application No. 2023-192957, filed on November 13, 2023, the entire contents of which are incorporated herein by reference.

### FIELD

Embodiments described herein relate generally to a semiconductor device and a method for manufacturing a semiconductor device.

### BACKGROUND

Silicon carbide (SiC) is expected as a material for next-generation semiconductor devices. As compared with silicon (Si), silicon carbide has excellent physical properties such as a band gap of about 3 times, a breakdown field strength of about 10 times, and a thermal conductivity of about 3 times. By utilizing these characteristics, it is possible to realize a power semiconductor device having a high breakdown voltage, with low loss, and capable of operating at a high temperature.

For example, a Schottky barrier diode (SBD) using silicon carbide is required to reduce a forward voltage (VF). By reducing the forward voltage (VF), for example, a low-loss SBD can be realized.

### BRIEF DESCRIPTION OF THE DRAWINGS

FIG. 1 is a schematic cross-sectional view of a semiconductor device according to a first embodiment;
FIG. 2 is an enlarged schematic cross-sectional view of a part of the semiconductor device according to the first embodiment;
FIG. 3 is a schematic cross-sectional view of a semiconductor device according to a comparative example of the first embodiment;
FIG. 4 is an enlarged schematic cross-sectional view of a part of the semiconductor device according to the comparative example of the first embodiment;
FIG. 5 is an explanatory diagram of functions and effects of the semiconductor device according to the first embodiment;
FIG. 6 is an explanatory diagram of functions and effects of the semiconductor device and a method for manufacturing the semiconductor device according to the first embodiment;
FIG. 7 is a schematic cross-sectional view of a semiconductor device according to a second embodiment;
FIG. 8 is a schematic cross-sectional view of a semiconductor device according to a third embodiment;
FIG. 9 is an enlarged schematic cross-sectional view of a part of the semiconductor device according to the third embodiment; and
FIG. 10 is a schematic cross-sectional view of a semiconductor device according to a fourth embodiment.

### DETAILED DESCRIPTION

A semiconductor device according to an embodiment includes a first electrode, a second electrode, a silicon carbide layer provided between the first electrode and the second electrode and including a first silicon carbide region of n type, a titanium nitride layer provided between the first electrode and the first silicon carbide region, and an intermediate layer provided between the titanium nitride layer and the first silicon carbide region and containing silicon nitride.

Hereinafter, embodiments of the present disclosure will be described with reference to the drawings. Note that in the following description, the same or similar members and the like are denoted by the same reference numerals, and the description of the members and the like once described may be appropriately omitted.

In addition, in the following description, when there are notations of n⁺, n, and n⁻ and p⁺, p, and p⁻, these notations represent relative levels of impurity concentration in each conductivity type. That is, n⁺ indicates that the n-type impurity concentration is relatively higher than n, and n⁻ indicates that the n-type impurity concentration is relatively lower than n. In addition, p⁺ indicates that the p-type impurity concentration is relatively higher than p, and p⁻ indicates that the p-type impurity concentration is relatively lower than p. Note that n⁺ type and n⁻ type may be simply referred to as n type, and p⁺ type and p⁻ type may be simply referred to as p type.

Note that in the present specification, the "p-type impurity concentration" of a silicon carbide region of p type means a net p-type impurity concentration obtained by subtracting the n-type impurity concentration of the region from the p-type impurity concentration of the region. In addition, the "n-type impurity concentration" of a silicon carbide region of n type means a net n-type impurity concentration obtained by subtracting the p-type impurity concentration of the region from the n-type impurity concentration of the region.

In addition, unless otherwise stated in the specification, the impurity concentration of a specific region means the maximum impurity concentration of the region.

The impurity concentration can be measured by, for example, secondary ion mass spectrometry (SIMS). In addition, the relative level of the impurity concentration can also be determined from the level of the carrier concentration obtained by, for example, scanning capacitance microscopy (SCM). In addition, the distances such as the width and depth of an impurity region can be obtained by, for example, SIMS. In addition, the distances such as the width and depth of the impurity region can be obtained from, for example, an image of SCM or an image of a scanning electron microscope (SEM). In addition, the thicknesses and the like of a conductive layer and an insulating layer can be measured, for example, on an image of an SEM, a transmission electron microscope (TEM), or a scanning transmission electron microscope (STEM). In addition, qualitative analysis and quantitative analysis of a chemical composition of members constituting the semiconductor device can be performed by, for example, SIMS, electron energy loss spectroscopy (EELS), and energy dispersive X-ray spectroscopy (EDX). In addition, the direction of the crystal axis of the crystal grain of the member constituting the semiconductor device can be determined, for example, from the atomic arrangement of the crystal grain observed in an image of a STEM.

### (First Embodiment)

A semiconductor device according to a first embodiment includes a first electrode, a second electrode, a silicon carbide layer provided between the first electrode and the second electrode and including a first silicon carbide region of n type, a titanium nitride layer provided between the first electrode and the first silicon carbide region, and an intermediate layer provided between the titanium nitride layer and the first silicon carbide region and containing silicon nitride.

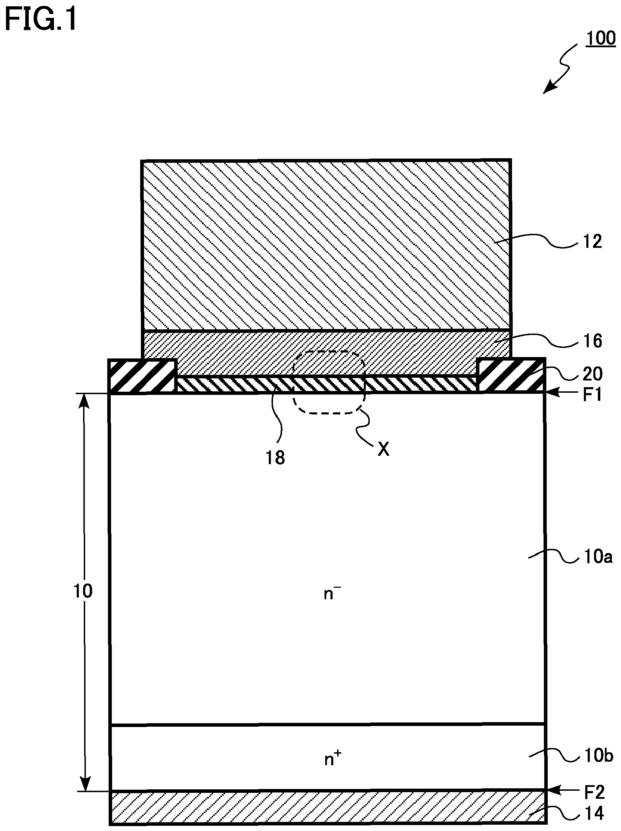

FIG. 1 is a schematic cross-sectional view of the semiconductor device according to the first embodiment. The semiconductor device according to the first embodiment is a Schottky barrier diode (SBD) 100 using silicon carbide.

The SBD 100 includes a silicon carbide layer 10, an anode electrode 12, a cathode electrode 14, a titanium nitride layer 16, an intermediate layer 18, and an insulating layer 20. The silicon carbide layer 10 includes a drift region 10a and a cathode region 10b.

The anode electrode 12 is an example of a first electrode. The cathode electrode 14 is an example of a second electrode. The drift region 10a is an example of a first silicon carbide region. The cathode region 10b is an example of a second silicon carbide region.

The silicon carbide layer 10 is provided between the anode electrode 12 and the cathode electrode 14.

The silicon carbide layer 10 is single crystal SiC. The silicon carbide layer 10 is, for example, 4H-SiC. The silicon carbide layer 10 includes a first face F1 and a second face F2. The second face F2 is opposite to the first face F1.

The first face F1 is a surface of the silicon carbide layer 10. The second face F2 is a back surface of the silicon carbide layer 10. The surface of the silicon carbide layer 10 is, for example, a face inclined at equal to or more than 0° and equal to or less than 8° with respect to the (0001) face.

The silicon carbide layer 10 includes a drift region 10a and a cathode region 10b.

At least a part of the drift region 10a is in contact with the first face F1. The drift region 10a is silicon carbide of n type. The drift region 10a contains an n-type impurity.

The n-type impurity contained in the drift region 10a is, for example, nitrogen (N) or phosphorus (P). The n-type impurity concentration of the drift region 10a is, for example, equal to or more than 1 × 10¹⁶ cm⁻³ and equal to or less than 5 × 10¹⁷ cm⁻³.

The cathode region 10b is provided between the drift region 10a and the second face F2. The cathode region 10b is in contact with, for example, the second face F2.

The cathode region 10b is silicon carbide of n type. The cathode region 10b contains an n-type impurity.

The n-type impurity contained in the cathode region 10b is, for example, nitrogen (N) or phosphorus (P). The n-type impurity concentration of the cathode region 10b is higher than the n-type impurity concentration of the drift region 10a. The n-type impurity concentration of the cathode region 10b is, for example, equal to or more than 1 × 10¹⁹ cm⁻³ and equal to or less than 5 × 10²¹ cm⁻³.

The anode electrode 12 is provided on the first face F1 side of the silicon carbide layer 10. The anode electrode 12 is provided above the silicon carbide layer 10.

The anode electrode 12 is a conductor. The anode electrode 12 contains, for example, a metal or a metal compound. The anode electrode 12 contains a material different from titanium nitride.

The anode electrode 12 contains, for example, aluminum (Al). The anode electrode 12 is, for example, an aluminum layer.

The cathode electrode 14 is provided on the second face F2 side of the silicon carbide layer 10. The cathode electrode 14 is provided under the silicon carbide layer 10.

The cathode electrode 14 is in contact with the second face F2. The cathode electrode 14 is in contact with the cathode region 10b.

The cathode electrode 14 is a conductor. The cathode electrode 14 contains, for example, a metal or a metal compound.

The cathode electrode 14 contains, for example, nickel silicide and titanium (Ti). The cathode electrode 14 has, for example, a stacked structure of nickel silicide, titanium (Ti), nickel (Ni), and gold (Au).

The titanium nitride layer 16 is provided between the anode electrode 12 and the silicon carbide layer 10. The titanium nitride layer 16 is provided between the anode electrode 12 and the drift region 10a. The titanium nitride layer 16 is in contact with, for example, the anode electrode 12.

The titanium nitride layer 16 is a conductor. The titanium nitride layer 16 contains titanium nitride. The chemical composition of titanium nitride contained in the titanium nitride layer 16 is, for example, TiNx (0.5 < x < 2) .

The thickness of the titanium nitride layer 16 is, for example, equal to or more than 10 nm and equal to or less than 300 nm. The thickness of the titanium nitride layer 16 is a thickness in a direction from the anode electrode 12 toward the cathode electrode 14. In other words, the thickness of the titanium nitride layer 16 is a thickness in a direction perpendicular to the surface of the silicon carbide layer 10.

The intermediate layer 18 is provided between the titanium nitride layer 16 and the silicon carbide layer 10. The intermediate layer 18 is provided between the titanium nitride layer 16 and the drift region 10a.

The intermediate layer 18 is in contact with, for example, the drift region 10a. The intermediate layer 18 is in contact with, for example, the titanium nitride layer 16.

The intermediate layer 18 contains silicon nitride. The intermediate layer 18 contains, for example, silicon nitride as a main component. The fact that the intermediate layer 18 contains silicon nitride as a main component means that the molar fraction of silicon nitride is the highest among the substances contained in the intermediate layer 18.

The thickness of the intermediate layer 18 is, for example, equal to or more than 0.5 nm and equal to or less than 3 nm. The thickness of the intermediate layer 18 is a thickness in the direction from the anode electrode 12 toward the cathode electrode 14. In other words, the thickness of the intermediate layer 18 is a thickness in the direction perpendicular to the surface of the silicon carbide layer 10.

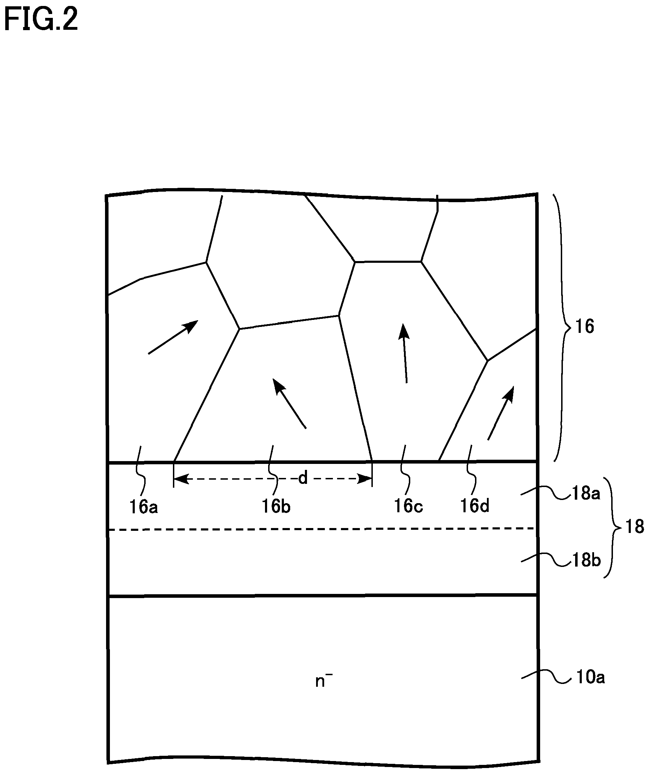

FIG. 2 is an enlarged schematic cross-sectional view of a part of the semiconductor device according to the first embodiment. FIG. 2 is a schematic cross-sectional view of a portion surrounded by dotted line X in FIG. 1. FIG. 2 is a cross section perpendicular to the surface of the silicon carbide layer 10.

The titanium nitride layer 16 is, for example, polycrystalline. The titanium nitride layer 16 includes, for example, a plurality of crystal grains of titanium nitride in contact with the intermediate layer 18. The titanium nitride layer 16 includes, for example, a plurality of crystal grains 16a, 16b, 16c, and 16d of titanium nitride in contact with the intermediate layer 18.

Crystal axes (indicated by arrows in FIG. 2) of the plurality of crystal grains of titanium nitride in contact with the intermediate layer 18 are oblique to each other. In other words, the plurality of crystal grains of titanium nitride in contact with the intermediate layer 18 are in contact with the intermediate layer 18 at faces having different face orientations.

For example, the crystal axes of the plurality of crystal grains 16a to 16d of titanium nitride are oblique to each other. For example, the crystal axes of the plurality of crystal grains 16a to 16d of titanium nitride are oriented in different directions. For example, the plurality of crystal grains 16a to 16d of titanium nitride are in contact with the intermediate layer 18 at faces having different face orientations.

Titanium nitride is a cubic crystal of sodium chloride type. The crystal axis indicated by an arrow in FIG. 2 is, for example, any one of the a-axis, the b-axis, and the c-axis.

Whether or not the crystal axes of the plurality of crystal grains of titanium nitride in contact with the intermediate layer 18 are oblique to each other can be determined, for example, from the atomic arrangement of the crystal grains observed in an image of a STEM. For example, when the directions of the atomic arrangements of crystal grains are oblique in adjacent crystal grains, it can be determined that the crystal axes of the crystal grains are oblique to each other.

A length (d in FIG. 2) of a portion where the intermediate layer 18 and one crystal grain of titanium nitride are in contact with each other is, for example, smaller than the thickness of the titanium nitride layer 16.

The intermediate layer 18 includes, for example, a first portion 18a and a second portion 18b. The second portion 18b is provided between the first portion 18a and the drift region 10a.

The nitrogen atom concentration of the first portion 18a is higher than the nitrogen atom concentration of the second portion 18b. For example, the nitrogen atom concentration in the intermediate layer 18 continuously decreases from the titanium nitride layer 16 toward the drift region 10a.

The insulating layer 20 is an insulator. The insulating layer 20 contains, for example, silicon oxide. The insulating layer 20 is, for example, a silicon oxide layer.

Next, an example of a method for manufacturing the semiconductor device according to the first embodiment will be described.

A method for manufacturing the semiconductor device according to the first embodiment includes: preparing a plurality of semiconductor substrates, each of the semiconductor substrates having a silicon carbide layer; forming a titanium nitride film on the silicon carbide layer; forming an intermediate layer containing silicon nitride between the silicon carbide layer and the titanium nitride film by performing a heat treatment on the plurality of semiconductor substrates in an atmosphere containing nitrogen; forming a metal film on the titanium nitride film; extracting one semiconductor substrate from the plurality of semiconductor substrates after forming the intermediate layer; and measuring a thickness of the intermediate layer in a cross section of the one semiconductor substrate.

First, a plurality of semiconductor wafers each having the silicon carbide layer 10 including the drift region 10a of n type and the cathode region 10b of n type are prepared. The semiconductor wafer is an example of a semiconductor substrate. The drift region 10a is formed on the cathode region 10b by, for example, an epitaxial growth method.

Next, a silicon oxide film is formed on the surface of the silicon carbide layer 10. The silicon oxide film is formed by, for example, a vapor deposition method or a thermal oxidation method. A part of the silicon oxide film finally becomes the insulating layer 20.

Next, an opening is formed in the insulating layer 20 using a lithography method and a reactive ion etching (RIE) method.

Next, a titanium nitride film is formed on the surface of the silicon carbide layer 10 exposed at the opening. A part of the titanium nitride film finally becomes the titanium nitride layer 16. The titanium nitride film is formed using, for example, a sputtering method.

Next, the titanium nitride film is patterned using, for example, a lithography method and an RIE method.

Next, a heat treatment is performed on the plurality of semiconductor wafers at a temperature of equal to or more than 500°C and equal to or less than 700°C. The heat treatment is performed in an atmosphere containing nitrogen. The heat treatment is performed, for example, in an atmosphere containing nitrogen and hydrogen.

By the heat treatment, the intermediate layer 18 containing silicon nitride is formed between the titanium nitride film and the silicon carbide layer 10. It is considered that nitrogen is diffused between the titanium nitride film and the silicon carbide layer 10 from the surface of the titanium nitride film or from a region without the titanium nitride film by the heat treatment, and the intermediate layer 18 containing silicon nitride is formed.

Next, one semiconductor wafer is extracted from the plurality of semiconductor wafers. The thickness of the intermediate layer 18 in a cross section of the extracted semiconductor wafer is measured. The thickness of the intermediate layer 18 is measured, for example, on an image of a STEM.

For example, when the thickness of the intermediate layer 18 is different from a desired thickness, the process conditions for the semiconductor wafer to be processed later are adjusted. For example, the temperature of the heat treatment is adjusted.

In addition, for example, when the thickness of the intermediate layer 18 is different from the desired thickness, it is determined that there is an abnormality in processing, and the processing on the semiconductor wafer other than the one semiconductor wafer is stopped.

Next, an aluminum film is formed on the titanium nitride film of the semiconductor wafer other than the one semiconductor wafer. A part of the aluminum film finally becomes the anode electrode 12.

Next, the aluminum film is patterned using, for example, a lithography method and an RIE method.

Then, the cathode electrode 14 is formed on the back surface of the silicon carbide layer 10 using a known process technique.

The SBD 100 according to the first embodiment illustrated in FIG. 1 is manufactured by the above-described method for manufacturing the semiconductor device.

Note that the one semiconductor wafer may be extracted, for example, after the aluminum film is formed.

In addition, the semiconductor wafer for measuring the thickness of the intermediate layer 18 may be a thickness monitoring dedicated semiconductor wafer joined to the plurality of semiconductor wafers immediately before the titanium nitride film is formed and extracted after the heat treatment.

In addition, the thickness of the intermediate layer 18 may be measured after the aluminum film is formed on the semiconductor wafer other than the one semiconductor wafer.

Next, functions and effects of the semiconductor device according to the first embodiment will be described.

In an SBD using silicon carbide, reduction of a forward voltage (VF) is required. By reducing the forward voltage (VF), for example, a low-loss SBD can be realized.

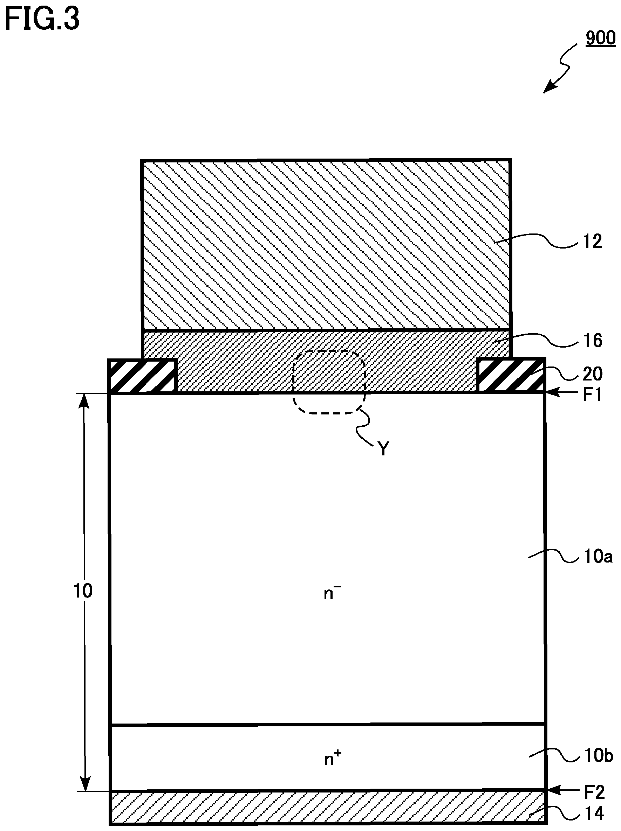

FIG. 3 is a schematic cross-sectional view of a semiconductor device according to a comparative example of the first embodiment. The semiconductor device according to the comparative example is an SBD 900. FIG. 3 is a diagram corresponding to FIG. 1 of the first embodiment.

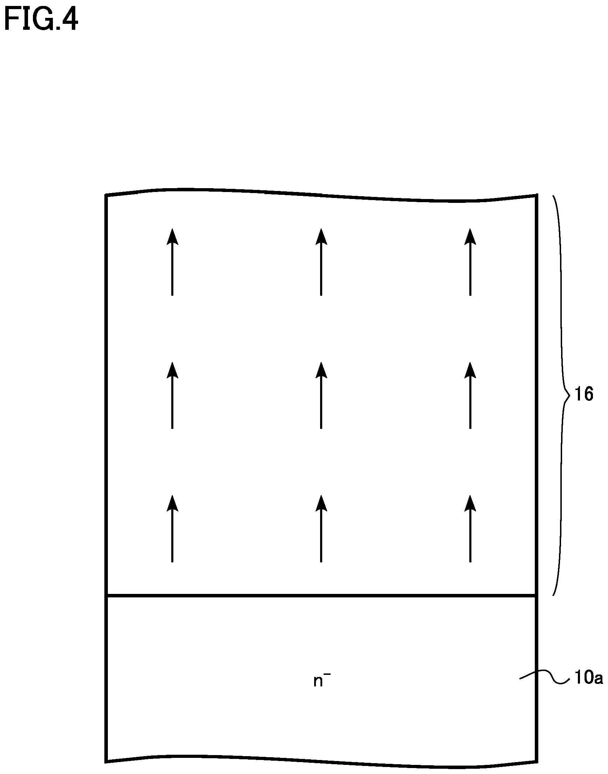

FIG. 4 is an enlarged schematic cross-sectional view of a part of the semiconductor device according to the comparative example of the first embodiment. FIG. 4 is a schematic cross-sectional view of a portion surrounded by dotted line Y in FIG. 3. FIG. 4 is a diagram corresponding to FIG. 2 of the first embodiment.

The SBD 900 includes the silicon carbide layer 10, the anode electrode 12, the cathode electrode 14, the titanium nitride layer 16, and the insulating layer 20. The silicon carbide layer 10 includes a drift region 10a and a cathode region 10b.

The SBD 900 is different from the SBD 100 according to the first embodiment in that the intermediate layer 18 is not provided.

In the SBD 900, the titanium nitride layer 16 and the silicon carbide layer 10 are in contact with each other. In the SBD 900, the titanium nitride layer 16 and the drift region 10a are in contact with each other.

The titanium nitride layer 16 is single crystalline. Therefore, crystal axes (indicated by arrows in FIG. 4) of titanium nitride in the titanium nitride layer 16 are aligned in one direction.

Next, an example of a method for manufacturing the semiconductor device according to the comparative example of the first embodiment will be described. A method for manufacturing the semiconductor device according to the comparative example of the first embodiment is different from the method for manufacturing the semiconductor device according to the first embodiment in that an aluminum film and a titanium nitride film are simultaneously patterned, a heat treatment is performed after the aluminum film is formed, and a temperature of the heat treatment is low.

The method for manufacturing the semiconductor device according to the comparative example of the first embodiment is similar to the method for manufacturing the semiconductor device according to the first embodiment described above until the titanium nitride film is formed on the surface of the silicon carbide layer 10.

Next, an aluminum film is formed on the titanium nitride film. A part of the aluminum film finally becomes the anode electrode 12.

Next, the aluminum film and the titanium nitride film are simultaneously patterned using, for example, a lithography method and an RIE method.

Next, for example, a heat treatment is performed at a temperature of 300°C. The heat treatment is performed in an atmosphere containing nitrogen. The heat treatment is performed, for example, in an atmosphere containing nitrogen and hydrogen.

Then, the cathode electrode 14 is formed on the back surface of the silicon carbide layer 10 using a known process technique.

The SBD 900 according to the comparative example illustrated in FIG. 3 is manufactured by the above-described method for manufacturing the semiconductor device.

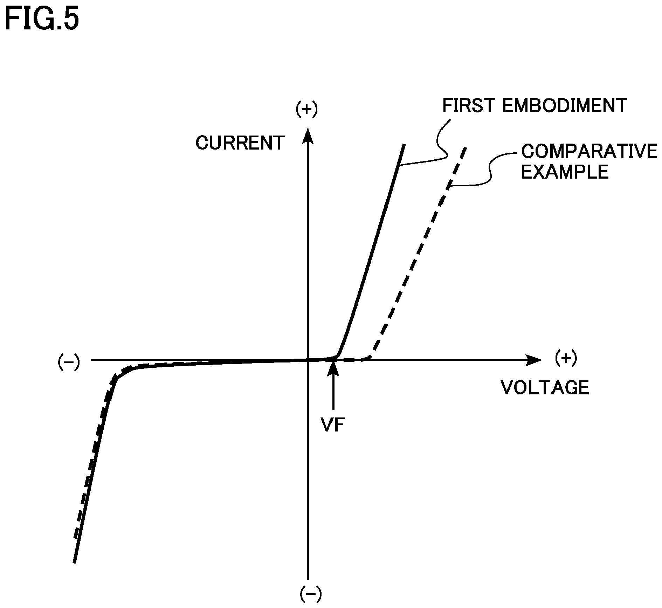

FIG. 5 is an explanatory diagram of functions and effects of the semiconductor device according to the first embodiment. FIG. 5 is a diagram illustrating voltage-current characteristics of the SBD 100 according to the first embodiment and the SBD 900 according to the comparative example.

As illustrated in FIG. 5, in the SBD 100 according to the first embodiment, the forward voltage (VF) is reduced as compared with the SBD 900 according to the comparative example. In the SBD 100, for example, a low-loss SBD can be realized by a reduction in the forward voltage (VF).

In the SBD 100 according to the first embodiment, it is considered that the forward voltage (VF) is reduced by a reduction in the Schottky barrier between the titanium nitride layer 16 and the drift region 10a. The reason why the Schottky barrier between the titanium nitride layer 16 and the drift region 10a is reduced in the SBD 100 is not necessarily clear, but it is considered that the Schottky barrier is reduced by the presence of the intermediate layer 18 containing silicon nitride.

For example, the presence of the intermediate layer 18 containing silicon nitride makes the titanium nitride layer 16 polycrystalline as illustrated in FIG. 2. Therefore, the titanium nitride layer 16 is in contact with the intermediate layer 18 at a plurality of faces having different face orientations. For example, it is conceivable that the work function of titanium nitride has face orientation dependency, and the titanium nitride layer 16 includes a plurality of faces having different face orientations, thus reducing the Schottky barrier.

The thickness of the titanium nitride layer 16 is preferably equal to or more than 10 nm and equal to or less than 300 nm, and more preferably equal to or more than 20 nm and equal to or less than 150 nm. When the thickness of the titanium nitride layer is equal to or more than the lower limit value, the forward voltage (VF) of the SBD 100 is stabilized. In addition, when the thickness of the titanium nitride layer 16 is equal to or less than the upper limit value, the stress of the titanium nitride layer 16 is reduced, and the warpage of the wafer at the time of manufacturing the SBD 100 is suppressed. By suppressing the warpage of the wafer, for example, the SBD 100 can be easily manufactured.

The length (d in FIG. 2) of the portion where the intermediate layer 18 and the crystal grain of titanium nitride are in contact with each other is preferably smaller than the thickness of the titanium nitride layer 16. The number of crystal grains of titanium nitride in contact with the intermediate layer 18 increases, and the forward voltage (VF) of the SBD 100 is further reduced.

The thickness of the intermediate layer 18 is preferably equal to or more than 0.5 nm and equal to or less than 3 nm. When the thickness of the intermediate layer 18 is equal to or more than 0.5 nm, the forward voltage (VF) of the SBD 100 is further reduced. In addition, when the thickness of the intermediate layer 18 is equal to or less than 3 nm, an on-current of the SBD 100 increases.

Preferably, the intermediate layer 18 includes the first portion 18a and the second portion 18b, and the nitrogen atom concentration of the first portion 18a is higher than the nitrogen atom concentration of the second portion 18b. By lowering the nitrogen atom concentration of the second portion 18b close to the drift region 10a, an excessive reduction in the forward voltage (VF) of the SBD 100 is suppressed.

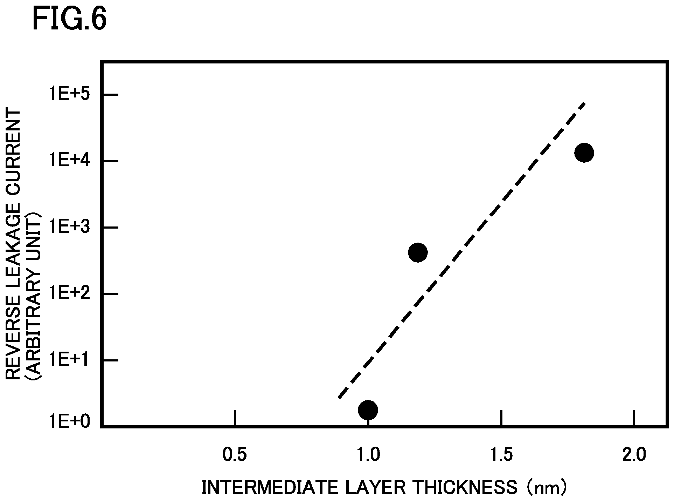

FIG. 6 is an explanatory diagram of functions and effects of the semiconductor device and the method for manufacturing the semiconductor device according to the first embodiment. FIG. 6 is a diagram illustrating a relationship between the thickness of the intermediate layer and a reverse leakage current of the SBD 100 according to the first embodiment.

As illustrated in FIG. 6, the reverse leakage current decreases as the thickness of the intermediate layer 18 decreases. From the viewpoint of reducing the reverse leakage current of the SBD 100, the thickness of the intermediate layer 18 is preferably thin. From the viewpoint of reducing the reverse leakage current of the SBD 100, the thickness of the intermediate layer 18 is preferably equal to or less than 1.5 nm, and more preferably equal to or less than 1.3 nm.

In the method for manufacturing the semiconductor device according to the first embodiment, the semiconductor wafer is extracted after the intermediate layer 18 is formed, and the thickness of the intermediate layer 18 is measured. By measuring the thickness of the intermediate layer 18, the magnitude of the reverse leakage current of the SBD 100 after the SBD 100 is manufactured can be predicted on the basis of the correlation illustrated in FIG. 6.

For example, when the thickness of the intermediate layer 18 is different from a desired thickness, the process conditions for the semiconductor wafer to be processed later are adjusted. Early feedback to the process conditions is enabled, and, for example, the manufacturing yield of the SBD 100 is improved.

For example, when the thickness of the intermediate layer 18 is different from the desired thickness, it is determined that there is an abnormality in processing, and subsequent processing on the semiconductor wafer other than the one semiconductor wafer is stopped. By stopping the manufacture of the SBD 100 predicted to be a defective product, for example, the manufacturing cost can be reduced.

As described above, the reverse leakage current decreases as the thickness of the intermediate layer 18 decreases. The thickness of the intermediate layer 18 is thinner as the temperature of the heat treatment for forming the intermediate layer 18 is lower, for example. From the viewpoint of reducing the thickness of the intermediate layer 18 and reducing the reverse leakage current of the SBD 100, the temperature of the heat treatment for forming the intermediate layer 18 is preferably equal to or less than 600°C.

The thickness of the intermediate layer 18 is thinner as the thickness of the titanium nitride film formed before the formation of the intermediate layer 18 is thicker. From the viewpoint of reducing the thickness of the intermediate layer 18 and reducing the reverse leakage current of the SBD 100, the thickness of the titanium nitride film formed before the formation of the intermediate layer 18 is preferably equal to or less than 250nm, more preferably equal to or less than 100nm, and further preferably equal to or less than 50nm.

As described above, according to the first embodiment, it is possible to realize an SBD capable of reducing the forward voltage (VF). In addition, it is possible to realize an improvement in the manufacturing yield of the SBD and a reduction in the manufacturing cost.

### (Second Embodiment)

A semiconductor device according to a second embodiment is different from the semiconductor device according to the first embodiment in that the silicon carbide layer further includes a third silicon carbide region of p type provided between the first silicon carbide region and the first electrode and a fourth silicon carbide region of p type provided between the first silicon carbide region and the first electrode, and the first silicon carbide region is provided between the third silicon carbide region and the fourth silicon carbide region. Hereinafter, description of contents overlapping with the first embodiment may be omitted.

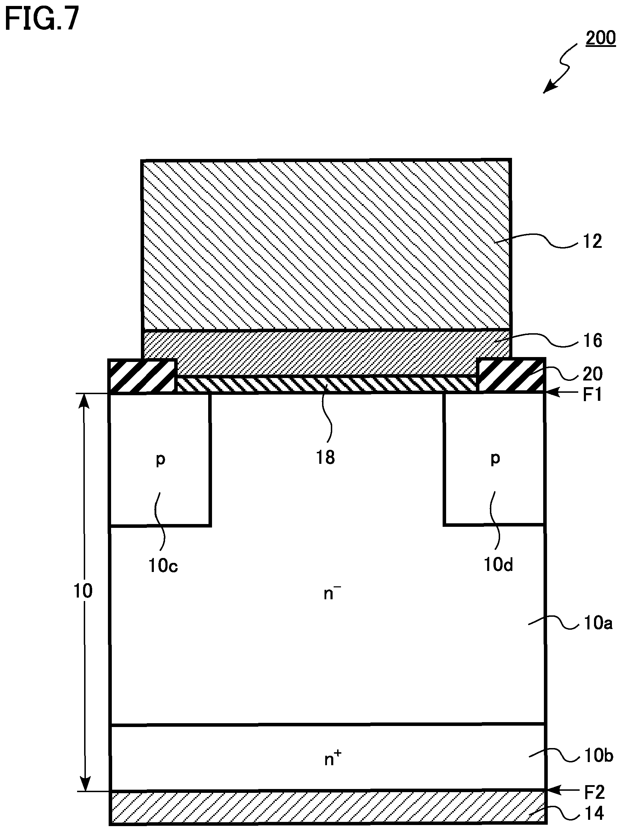

FIG. 7 is a schematic cross-sectional view of the semiconductor device according to the second embodiment. The semiconductor device according to the second embodiment is an SBD 200 using silicon carbide. The SBD 200 has a so-called junction barrier Schottky structure (JBS structure) in which a pn junction and a Schottky junction are combined.

The SBD 200 includes a silicon carbide layer 10, an anode electrode 12, a cathode electrode 14, a titanium nitride layer 16, an intermediate layer 18, and an insulating layer 20. The silicon carbide layer 10 includes a drift region 10a, a cathode region 10b, a first p-type region 10c, and a second p-type region 10d.

The anode electrode 12 is an example of a first electrode. The cathode electrode 14 is an example of a second electrode. The drift region 10a is an example of a first silicon carbide region. The cathode region 10b is an example of a second silicon carbide region. The first p-type region 10c is an example of a third silicon carbide region. The second p-type region 10d is an example of a fourth silicon carbide region.

The first p-type region 10c is provided between the drift region 10a and the anode electrode 12. The first p-type region 10c is provided between the drift region 10a and a first face F1. The first p-type region 10c is in contact with the first face F1.

The first p-type region 10c is silicon carbide of p type. The first p-type region 10c contains a p-type impurity.

The p-type impurity contained in the first p-type region 10c is, for example, aluminum (Al). The p-type impurity concentration of the first p-type region 10c is, for example, equal to or more than 1 × 10¹⁸ cm⁻³ and equal to or less than 1 × 10²⁰ cm⁻³.

The second p-type region 10d is provided between the drift region 10a and the anode electrode 12. The second p-type region 10d is provided between the drift region 10a and the first face F1. The second p-type region 10d is in contact with the first face F1.

A part of the drift region 10a is provided between the first p-type region 10c and the second p-type region 10d. The part of the drift region 10a provided between the first p-type region 10c and the second p-type region 10d is in contact with the first face F1. The part of the drift region 10a provided between the first p-type region 10c and the second p-type region 10d is in contact with the intermediate layer 18.

The second p-type region 10d is silicon carbide of p type. The second p-type region 10d contains a p-type impurity.

The p-type impurity contained in the second p-type region 10d is, for example, aluminum (Al). The p-type impurity concentration of the second p-type region 10d is, for example, equal to or more than 1 × 10¹⁸ cm⁻³ and equal to or less than 1 × 10²⁰ cm⁻³.

When a reverse bias is applied to the SBD 200, for example, a depletion layer extending from the first p-type region 10c and the second p-type region 10d to the drift region 10a covers an interface between the intermediate layer 18 and the drift region 10a. Therefore, according to the SBD 200, a leakage current when the reverse bias is applied is reduced as compared with the SBD 100. In other words, according to the SBD 200, an off-leakage current is reduced as compared with the SBD 100.

As described above, according to the second embodiment, it is possible to realize an SBD capable of reducing the forward voltage (VF). In addition, it is possible to realize an SBD in which the off-leakage current is reduced.

### (Third Embodiment)

A semiconductor device according to a third embodiment includes a first electrode; a second electrode; a silicon carbide layer provided between the first electrode and the second electrode and including a first silicon carbide region of n type; a vanadium nitride layer provided between the first electrode and the first silicon carbide region; and an intermediate layer provided between the vanadium nitride layer and the first silicon carbide region and containing silicon nitride. The semiconductor device according to a third embodiment is different from the semiconductor device according to the first embodiment in that the semiconductor device includes the vanadium nitride layer instead of the titanium nitride layer. Hereinafter, description of contents overlapping with the first embodiment may be omitted.

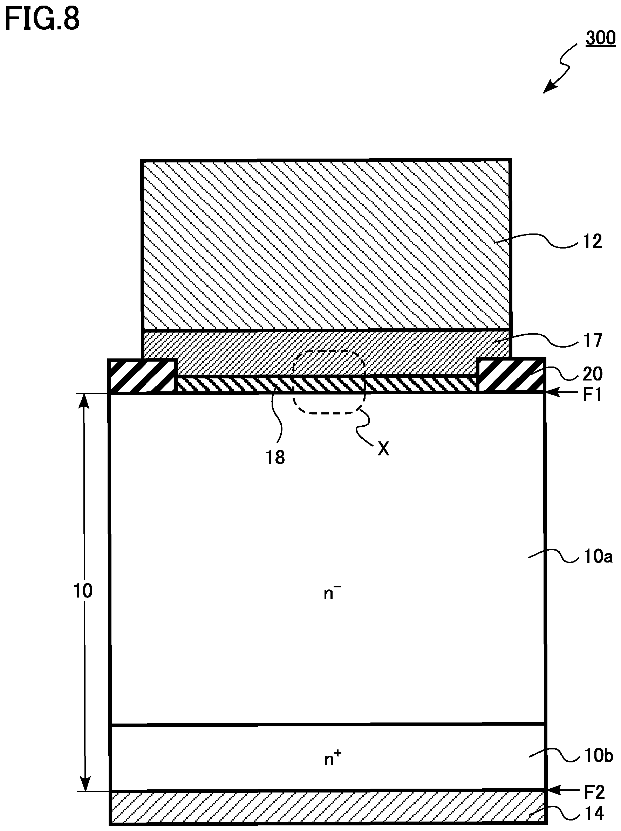

FIG. 8 is a schematic cross-sectional view of the semiconductor device according to the third embodiment. The semiconductor device according to the third embodiment is a Schottky barrier diode (SBD) 300 using silicon carbide.

The SBD 300 includes a silicon carbide layer 10, an anode electrode 12, a cathode electrode 14, a vanadium nitride layer 17, an intermediate layer 18, and an insulating layer 20. The silicon carbide layer 10 includes a drift region 10a and a cathode region 10b.

The vanadium nitride layer 17 is provided between the anode electrode 12 and the silicon carbide layer 10. The vanadium nitride layer 17 is provided between the anode electrode 12 and the drift region 10a. The vanadium nitride layer 17 is in contact with, for example, the anode electrode 12.

The vanadium nitride layer 17 is a conductor. The vanadium nitride layer 17 contains vanadium nitride. The chemical composition of vanadium nitride contained in the vanadium nitride layer 17 is, for example, VNx (0.5 ≤ x < 2).

The thickness of vanadium nitride layer 17 is, for example, equal to or more than 10 nm and equal to or less than 300 nm. The thickness of the vanadium nitride layer 17 is a thickness in a direction from the anode electrode 12 toward the cathode electrode 14. In other words, the thickness of the vanadium nitride layer 17 is a thickness in a direction perpendicular to the surface of the silicon carbide layer 10.

The intermediate layer 18 is provided between the vanadium nitride layer 17 and the silicon carbide layer 10. The intermediate layer 18 is provided between the vanadium nitride layer 17 and the drift region 10a.

The intermediate layer 18 is in contact with, for example, the drift region 10a. The intermediate layer 18 is in contact with, for example, the vanadium nitride layer 17.

The intermediate layer 18 contains silicon nitride. The intermediate layer 18 contains, for example, silicon nitride as a main component. The fact that the intermediate layer 18 contains silicon nitride as a main component means that the molar fraction of silicon nitride is the highest among the substances contained in the intermediate layer 18.

The thickness of the intermediate layer 18 is, for example, equal to or more than 0.5 nm and equal to or less than 3 nm. The thickness of the intermediate layer 18 is a thickness in the direction from the anode electrode 12 toward the cathode electrode 14. In other words, the thickness of the intermediate layer 18 is a thickness in the direction perpendicular to the surface of the silicon carbide layer 10.

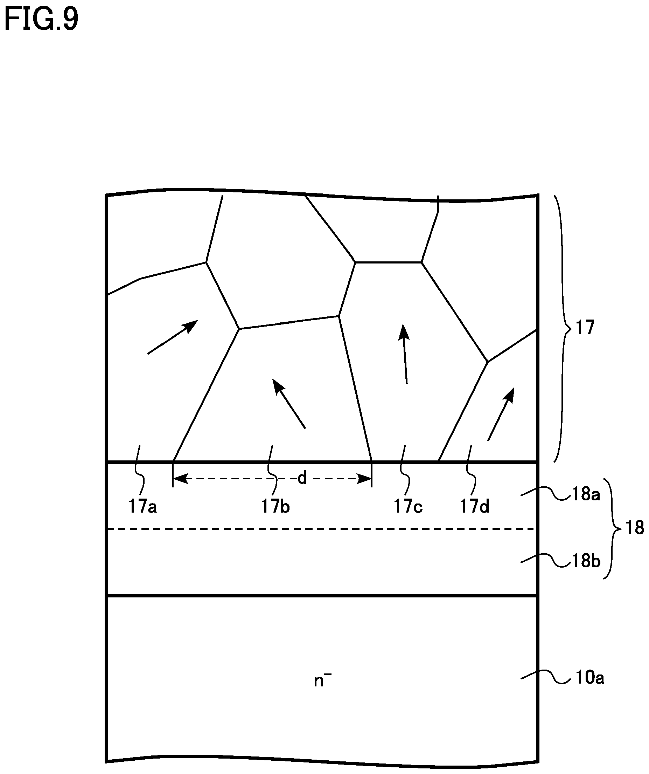

FIG. 9 is an enlarged schematic cross-sectional view of a part of the semiconductor device according to the third embodiment. FIG. 9 is a schematic cross-sectional view of a portion surrounded by dotted line X in FIG. 8. FIG. 9 is a cross section perpendicular to the surface of the silicon carbide layer 10.

The vanadium nitride layer 17 is, for example, polycrystalline. The vanadium nitride layer 17 includes, for example, a plurality of crystal grains of vanadium nitride in contact with the intermediate layer 18. The vanadium nitride layer 17 includes, for example, a plurality of crystal grains 17a, 17b, 17c, and 17d of vanadium nitride in contact with the intermediate layer 18.

Crystal axes (indicated by arrows in FIG. 2) of the plurality of crystal grains of vanadium nitride in contact with the intermediate layer 18 are oblique to each other. In other words, the plurality of crystal grains of vanadium nitride in contact with the intermediate layer 18 are in contact with the intermediate layer 18 at faces having different face orientations.

For example, the crystal axes of the plurality of crystal grains 17a to 17d of vanadium nitride are oblique to each other. For example, the crystal axes of the plurality of crystal grains 17a to 17d of vanadium nitride are oriented in different directions. For example, the plurality of crystal grains 17a to 17d of vanadium nitride are in contact with the intermediate layer 18 at faces having different face orientations.

Vanadium nitride is a cubic crystal of sodium chloride type. The crystal axis indicated by an arrow in FIG. 9 is, for example, any one of the a-axis, the b-axis, and the c-axis.

Whether or not the crystal axes of the plurality of crystal grains of vanadium nitride in contact with the intermediate layer 18 are oblique to each other can be determined, for example, from the atomic arrangement of the crystal grains observed in an image of a STEM. For example, when the directions of the atomic arrangements of crystal grains are oblique in adjacent crystal grains, it can be determined that the crystal axes of the crystal grains are oblique to each other.

A length (d in FIG. 9) of a portion where the intermediate layer 18 and one crystal grain of vanadium nitride are in contact with each other is, for example, smaller than the thickness of the vanadium nitride layer 17.

The intermediate layer 18 includes, for example, a first portion 18a and a second portion 18b. The second portion 18b is provided between the first portion 18a and the drift region 10a.

The nitrogen atom concentration of the first portion 18a is higher than the nitrogen atom concentration of the second portion 18b. For example, the nitrogen atom concentration in the intermediate layer 18 continuously decreases from the titanium nitride layer 16 toward the drift region 10a.

The insulating layer 20 is an insulator. The insulating layer 20 contains, for example, silicon oxide. The insulating layer 20 is, for example, a silicon oxide layer.

The semiconductor device of the third embodiment may be manufactured by replacing the titanium nitride film with a vanadium nitride film in the manufacturing process of the first embodiment.

As described above, according to the third embodiment, similar to the first embodiment, it is possible to realize an SBD capable of reducing the forward voltage (VF). In addition, it is possible to realize an improvement in the manufacturing yield of the SBD and a reduction in the manufacturing cost.

### (Fourth Embodiment)

A semiconductor device according to a fourth embodiment is different from the semiconductor device according to the third embodiment in that the silicon carbide layer further includes a third silicon carbide region of p type provided between the first silicon carbide region and the first electrode and a fourth silicon carbide region of p type provided between the first silicon carbide region and the first electrode, and the first silicon carbide region is provided between the third silicon carbide region and the fourth silicon carbide region. The semiconductor device according to a fourth embodiment is different from the semiconductor device according to the second embodiment in that the semiconductor device includes the vanadium nitride layer instead of the titanium nitride layer. Hereinafter, description of contents overlapping with the third or second embodiment may be omitted.

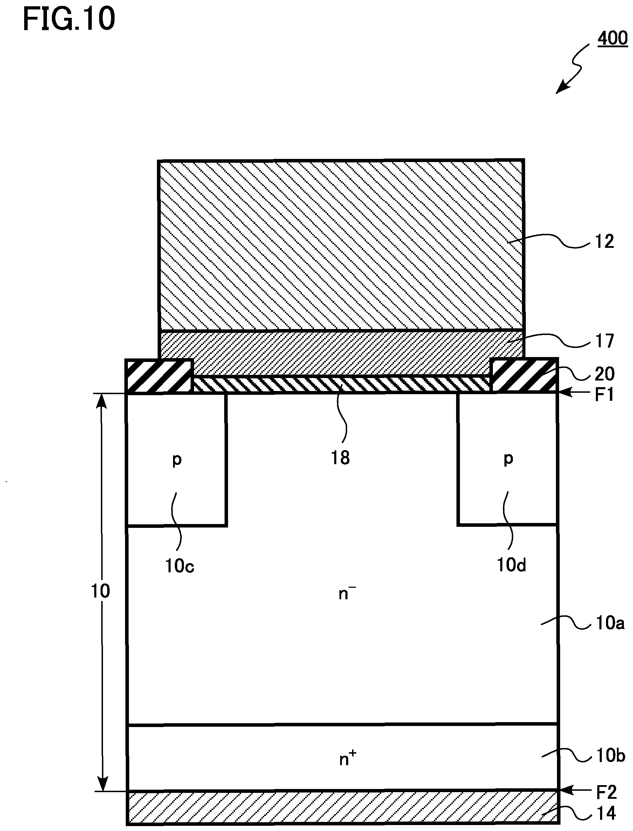

FIG. 10 is a schematic cross-sectional view of the semiconductor device according to the fourth embodiment. The semiconductor device according to the second embodiment is an SBD 400 using silicon carbide. The SBD 400 has a so-called junction barrier Schottky structure (JBS structure) in which a pn junction and a Schottky junction are combined.

The SBD 400 includes a silicon carbide layer 10, an anode electrode 12, a cathode electrode 14, a vanadium nitride layer 17, an intermediate layer 18, and an insulating layer 20. The silicon carbide layer 10 includes a drift region 10a, a cathode region 10b, a first p-type region 10c, and a second p-type region 10d.

According to the fourth embodiment, similar to the third embodiment, it is possible to realize an SBD capable of reducing the forward voltage (VF). In addition, it is possible to realize an SBD in which the off-leakage current is reduced.

In the first to fourth embodiments, an example has been described in which the crystal structure of SiC is 4H-SiC, but the present disclosure can also be applied to devices using SiC having other crystal structures such as 6H-SiC and 3C-SiC. In addition, it is also possible to apply a face other than the (0001) face to the surface of the silicon carbide layer 10.

In the first to fourth embodiments, aluminum (Al) has been exemplified as the p-type impurity, but boron (B) can also be used. In addition, nitrogen (N) and phosphorus (P) have been exemplified as the n-type impurity, but arsenic (As), antimony (Sb), and the like can also be applied.

While certain embodiments have been described, these embodiments have been presented by way of example only, and are not intended to limit the scope of the inventions. Indeed, the semiconductor device and the method for manufacturing a semiconductor device described herein may be embodied in a variety of other forms; furthermore, various omissions, substitutions and changes in the form of the devices and methods described herein may be made without departing from the spirit of the inventions. The accompanying claims and their equivalents are intended to cover such forms or modifications as would fall within the scope and spirit of the inventions.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A semiconductor device (100,200) comprising:
a first electrode (12);
a second electrode (14);
a silicon carbide layer (10) provided between the first electrode (12) and the second electrode (14) and including a first silicon carbide region (10a) of n type;
a titanium nitride layer (16) provided between the first electrode (12) and the first silicon carbide region (10a); and
an intermediate layer (18) provided between the titanium nitride layer (16) and the first silicon carbide region (10a) and containing silicon nitride.

2. The semiconductor device (100,200) according to claim 1, wherein the intermediate layer (18) and the first silicon carbide region (10a) are in contact with each other, and the intermediate layer (18) and the titanium nitride layer (16) are in contact with each other.

3. The semiconductor device (100,200) according to claim 1 or 2, wherein the titanium nitride layer (16) is polycrystalline.

4. The semiconductor device (100,200) according to claim 3, wherein the titanium nitride layer (16) includes a plurality of crystal grains (16a,16b,16c,16d) in contact with the intermediate layer (18), and crystal axes of the plurality of crystal grains (16a,16b,16c,16d) are oblique to each other.

5. The semiconductor device (100,200) according to any one of claims 1 to 4, wherein the intermediate layer (18) includes a first portion (18a) and a second portion (18b) provided between the first portion (18a) and the first silicon carbide region (10a), and a nitrogen atom concentration of the first portion (18a) is higher than a nitrogen atom concentration of the second portion (18b).

6. The semiconductor device (100,200) according to any one of claims 1 to 5, wherein the intermediate layer (18) has a thickness of equal to or more than 0.5 nm and equal to or less than 3 nm.

7. The semiconductor device (100,200) according to any one of claims 1 to 6, wherein the first silicon carbide region (10a) has an n-type impurity concentration of equal to or more than 1 × 10¹⁶ cm⁻³ and equal to or less than 5 × 10¹⁷ cm⁻³.

8. The semiconductor device(100,200) according to any one of claims 1 to 7, wherein the silicon carbide layer (10) further includes a second silicon carbide region (10b) of n type provided between the first silicon carbide region(10a) and the second electrode (14), the second silicon carbide region (10b) being in contact with the second electrode (14), and the second silicon carbide region (10b) has an n-type impurity concentration higher than an n-type impurity concentration of the first silicon carbide region (10a).

9. The semiconductor device (200) according to claim 8, wherein the silicon carbide layer (10) further includes
a third silicon carbide region (10c) of p type provided between the first silicon carbide region (10a) and the first electrode (12) and
a fourth silicon carbide region (10d) of p type provided between the first silicon carbide region (10a) and the first electrode (10d), and
a part of the first silicon carbide region (10a) is provided between the third silicon carbide region (10c) and the fourth silicon carbide region (10d).

10. A method for manufacturing a semiconductor device (100,200), comprising:
preparing a plurality of semiconductor substrates, each of the semiconductor substrates having a silicon carbide layer (10);
forming a titanium nitride film (16) on the silicon carbide layer;
forming an intermediate layer (18) containing silicon nitride between the silicon carbide layer (10) and the titanium nitride film (16) by performing a heat treatment on the plurality of semiconductor substrates in an atmosphere containing nitrogen;
forming a metal film (12) on the titanium nitride film (16) ;
extracting one semiconductor substrate from the plurality of semiconductor substrates after the forming the intermediate layer (18); and
measuring a thickness of the intermediate layer (18) in a cross section of the one semiconductor substrate.

11. The method for manufacturing a semiconductor device (100,200) according to claim 10, wherein the one semiconductor substrate is extracted before the forming the metal film.

12. The method for manufacturing a semiconductor device (100,200) according to claim 10 or 11, wherein a temperature of the heat treatment is equal to or more than 500°C and equal to or less than 700°C.

13. The method for manufacturing a semiconductor device(100,200) according to claim 10 or 11, wherein the metal film contains aluminum.

14. A semiconductor device (300,400) comprising:
a first electrode (12);
a second electrode (14);
a silicon carbide layer (10) provided between the first electrode (12) and the second electrode (14) and including a first silicon carbide region (10a) of n type;
a vanadium nitride layer (17) provided between the first electrode (12) and the first silicon carbide region (10a); and
an intermediate layer (18) provided between the vanadium nitride layer (17) and the first silicon carbide region (10a) and containing silicon nitride.

15. The semiconductor device (300,400) according to claim 14, wherein the intermediate layer (18) and the first silicon carbide region (10a) are in contact with each other, and the intermediate layer (18) and the vanadium nitride layer (17) are in contact with each other.

16. The semiconductor device (300,400) according to claim 14 or 15, wherein the vanadium nitride layer (17) is polycrystalline.

17. The semiconductor device according (300,400) to claim 16, wherein the vanadium nitride layer (17) includes a plurality of crystal grains (17a,17b,17c,17d) in contact with the intermediate layer (18), and crystal axes of the plurality of crystal grains (17a,17b,17c,17d) in contact with the intermediate layer (18), and crystal are oblique to each other.

18. The semiconductor device (300,400) according to any one of claims 14 to 16, wherein the intermediate layer includes (18) a first portion (18a) and a second portion (18b) provided between the first portion (18a) and the first silicon carbide region(10a), and a nitrogen atom concentration of the first portion (18a) is higher than a nitrogen atom concentration of the second portion (18b).

19. The semiconductor device (300,400) according to claim 14, wherein the intermediate layer (18) has a thickness of equal to or more than 0.5 nm and equal to or less than 3 nm.

20. The semiconductor device according to (300,400) any one of claims 14 to 19, wherein the first silicon carbide region (10a) has an n-type impurity concentration of equal to or more than 1 × 10¹⁶ cm⁻³ and equal to or less than 5 × 10¹⁷ cm⁻³.
